# EUROPEAN PATENT APPLICATION

(11) **EP 4 478 614 A1**
(43) Date of publication of application: **18.12.2024**
(21) Application number: 24155481.5
(22) Date of filing: 02.02.2024
(51) Int. Cl.: H03K 17/16, H03K 17/0812, H02M 1/088

(54) **POWER SEMICONDUCTOR BRIDGE LEG ARRANGEMENT**

(30) Priority: 12.06.2023 EP 23178736
(71) Applicant: Siemens Gamesa Renewable Energy A/S, 7330 Brande (DK)
(72) Inventor: The designation of the inventor has not yet been filed
(74) Representative: SGRE-Association

(57) **Abstract**

The invention refers to a power semiconductor bridge leg arrangement (1), comprising a first connection point (2) and a second connection point (3), which are to be connected to a DC-voltage source (4), and a midpoint (5) as output, a switching arrangement (10) having a number of semiconductor switching elements (6) connected between the first connection point (2) and the second connection point (3), and a control circuit (7) for controlling the number of semi-conductor switching elements (6) of the switching arrangement (10). The invention is characterized in that the switching arrangement (10) comprises at least two individual power semiconductor half-bridge modules (11, 12, 13) connected in parallel between the first connection point (2) and the second connection point (3), each half-bridge module (11, 12, 13) comprising a high-side semiconductor switch (11H, 12H, 13H) and a low-side semiconductor switch (11L, 12L, 13L) being connected to a half-bridge midpoint (11M, 12M, 13M), where the half-bridge midpoint (11M, 12M, 13M) is connected to the midpoint (5) of the bridge leg arrangement(1) with a dedicated designed inductance (L1, L2, L3). Furthermore, the control circuit (7) is adapted to individually control the switch operations of each semiconductor switch (11H, 11L, 12H, 12L, 13H, 13L) of the at least two individual power semiconductor half-bridge modules (11, 12, 13).

## Description

The present invention relates to a power semiconductor bridge leg arrangement, comprising a switching arrangement having a number of semiconductor switching elements connected between a first connection point and a second connection point, which are connected to a DC-voltage source, and a control circuit for controlling the number of semiconductor switching elements of the switching arrangement.

In such switching arrangements, several problems may occur which relate to voltage overshoot during turn-off of a semiconductor device, oscillatory behavior resulting in electromagnetic interference (EMI) generation, and generation of rate of change of voltage increase or decrease (dV/dt) by semiconductor devices during turn-on and turn-off switching events.

In order to deal with the first two problems, DC-loop inductances and inductances of the switching arrangement are designed such to be as low as possible. Controlling of the semiconductor devices is made such to reduce the rate of change of current (dI/dt) through the semiconductor device during turn-off by using higher value gate resistances at the cost of increased switching losses. Sometimes, snubber circuits are connected in parallel with the semiconductor devices. In addition, active gate driving may be used to actively shape the switching trajectory of the semiconductor device which however may result at some cost of increased switching losses, and significant unresolved challenges in implementing a closed-loop system.

In order to limit the rate of change of voltage increase/decrease across the semiconductor device during turn-on/turn-off the size of the gate resistor size may be increased at the cost of increased switching losses.

In order to deal with at least some of the above-mentioned problems, switching arrangements have been proposed consisting of a number of parallel half-bridges. The solutions proposed in [1], [2], and [3] are based around using an interphase transformer in conjunction with delay based active gate driving with the primary aim of a reduction in the rate of change of voltage increase/decrease.

Active gate driving may be used to facilitate current balancing between power semiconductor switching elements, such as Silicon-Carbide (SiC)-devices. There are two primary configurations. Drive strength based active gate driving adjusts the magnitude of the voltage or current applied to individual gates of switching elements over the switching transient, aiming to balance of the drain source voltage and drain currents. Delay based active gate drivers apply delays to conventional drive signals applied to the individual gates. This compensates for the variants in threshold voltages between devices and allows for dynamic balancing of the drain source voltage and drain current.
[1] proposes a delay based active gate driving in conjunction with interphase transformers (differential chokes) to facilitate current balancing and a reduced rate of voltage change (dV/dt). For n parallel half-bridges (n-1) interphase transformers between the phases are required. As a disadvantage, this topology requires an even number of half-bridges. In order to provide dynamic and static current sharing in the parallel connected half-bridges, a balancing method is used, where the delay is implemented based on a comparator determining which device has the most current, then using a fixed delay to attempt to balance it. As a further drawback, drain-source overshoot, damping, and energy loss reductions are not considered by the topology proposed in [1].

In [2] and [3] a solution is described which primarily optimizes the rate of change of voltage increase/decrease at the output of the bridge leg through staggered switching of the switching elements of the bridge leg arrangement. Active current balancing only refers to balancing the cross current through an interphase transformer to avoid saturating its core. An additional LC-filter is added to improve the output waveform quality. Furthermore, a controller for cross current is presented which uses a variable switching delay to reduce the cross current. As a drawback, drain-source overshoot, damping, and energy loss reductions are not considered.

It is therefore an object of the present invention to provide an improved power semiconductor bridge leg arrangement.

This object is solved by a power semiconductor bridge leg arrangement according to the features of claim 1. Preferred embodiments of the invention are set out in the dependent claims.

The power semiconductor bridge leg arrangement comprises a first connection point and a second connection point, which are to be connected to a DC-voltage source, and a midpoint as output. A switching arrangement comprises a number of semiconductor switching elements (=semiconductor devices) connected between the first connection point and the second connection point. A control circuit is provided for controlling the number of semiconductor switching elements of the switching arrangement.

The switching arrangement comprises at least two individual power semiconductor half-bridge modules connected in parallel between the first connection point and the second connection point. Each half-bridge module comprises a controllable high-side semiconductor switch and a controllable low-side semiconductor switch being connected to a half-bridge midpoint. Each half-bridge midpoint is connected to the midpoint of the bridge leg arrangement with a dedicated designed inductance. The control circuit is adapted to individually control the switch operations of each semiconductor switch of the at least two individual power semiconductor half-bridge modules. The term "half-bridge module" is to be understood in the sense that it may comprise a power module with two semiconductor switches, or it may be formed from two individual dedicated semiconductor switches connected with each other.

The power semiconductor bridge leg arrangement according to the invention represents, from an external converter perspective, a composite switch that can be operated as a single bridge leg. The number of individual power semiconductor half-bridge modules is arbitrary. In particular, the number of half-bridge modules may be even or odd due to the use of individual dedicated designed inductances.

The bridge leg arrangement utilizes a combination of additional inductances and active-gate driving in terms of individually and independently controlling turn-on and turn-off gating signals of the individual semiconductor switches. Current balancing is achieved in parallel half-bridges through a combination of the dedicated designed inductances for current imbalance control purposes and to limit excessive current mis-share as well as active gate-driving in terms of individually controlling the semiconductor switches. The bridge leg arrangement has the advantage that is does not rely upon precise matching of circuit impedance and device characteristic matching in order to achieve current sharing. Nevertheless, it is robust against characteristic variation due to aging and environmental factors.

According to a preferred embodiment of the present invention, the control circuit is adapted to generate an individual dedicated control signal (=gating signal) for each semiconductor switch of the at least two individual power semiconductor half-bridge modules and provide it to an associated driver. The term "individual dedicated control signal" is to be understood such that timing and/or control parameters with respect to the adjustment of the magnitude of the voltage or current applied to individual gates may be selected individually.

According to a further preferred embodiment, the control circuit is adapted to skew the switching on/off triggering signals of each individual power semiconductor half-bridge module. By skewing the switching on/off gate triggering signals of each individual half-bridge within the bridge leg arrangement, a mechanism for balancing the current flowing through each half-bridge that forms the overall bridge leg is achieved. The dedicated designed inductances (= balancing inductances) limit the magnitude of change in currents during the switching transition.

According to a further preferred embodiment, the control circuit is adapted to control the order in which the individual semiconductor switches of the at least two individual power semiconductor half-bridge modules are turned-on/turned-off to control balancing of the currents flowing through each individual half-bridge module. By controlling the order in which the individual devices are turned-on/turned-off active control over the balancing of the currents flowing through each individual half-bridge can be achieved. This is achieved because the difference in half-bridge midpoint voltages results in a current flowing between the parallel branches, limited in magnitude by the length of the timing skew and the magnitude of the dedicated designed inductances. Opportunities to achieve active current balances are therefore present at every switching event (i.e., both turn-on and turn-off) the power semiconductor bridge leg undergoes.

According to a further preferred embodiment, the control circuit may be adapted to control the order of switching based on phase measurements of currents and/or voltages or based on a given schedule.

In particular, the timing skew between the individual bridge modules is in a range between 5 ns and 100 ns, preferably in a range between 5 ns and 50 ns, and more preferably in a range between 5 ns and 25 ns. Thus, the bridge leg arrangement according to the invention uses sub-microsecond delays to achieve balancing. This means, the required timing skews are achievable on an FPGA (Field Programmable Gate Array).

According to a further preferred embodiment, the timing skew between two individual bridge modules corresponds to the same order of the LC oscillation frequency of the power semiconductor bridge leg arrangement, i.e., is of the same order of magnitude as the time period of the LC oscillation frequency of the power semiconductor bridge leg arrangement. This preferred embodiment considers the effect of a parasitic inductance of a DC bus which may be a combination of any busbar/connection parasitic inductance, and the parasitic inductance of any DC bus capacitors. As a result of the employed staggered switching, the overall effective dI/dt though the DC bus parasitic inductance can be reduced. This reduces voltage overshoot and oscillations experienced by each of the switching elements during turn-off, as well as energy-loss incurred during the switching transition of each individual switching element. The magnitude of this benefit for later switching devices may be maximized by selecting the applied timing skew such that the individual commutation loop current contributions from each individual bridge leg interferes with each other such that the overall dI/dt through the DC bus parasitic inductance is further reduced. The skew required to achieve this is of the order of the time period of the LC oscillations between the output capacitance of the switching elements, and the combined busbar/DC capacitor/switching element package inductance. Reductions in the overshoot in current through the switching elements at turn-on can also be achieved by a similar mechanism of selecting a timing skew such that interference between the commutation loop currents results in a reduction in current overshoot magnitude.

According to a further preferred embodiment, the number of dedicated designed inductances corresponds to the number of individual power semiconductor half-bridge modules. In other words, each half-bridge module is associated with a dedicated designed inductance.

The dedicated designed inductances may be composed of individual wound inductors or parasitic inductances of busbar or cabling used to connect the switching element together at the midpoint.

The semiconductor switches may be MOSFETs (Metal-Oxide-Semiconductor Field-Effect Transistor) or IGBTs (Insulated Gate Bipolar Transistor), in particular based on Silicon-Carbide (SiC) or Silicon (Si).

The invention will be explained in more detail by reference to the accompanying figures.
- Fig. 1: shows a power semiconductor bridge leg arrangement according to the prior art.
- Fig. 2: shows a power semiconductor bridge leg arrangement according to an embodiment of the invention.
- Fig. 3: shows the bridge leg arrangement according to Fig. 2 illustrating respective voltages across low-side semiconductor switches and currents through dedicated designed inductances.
- Fig. 4: shows timing diagrams during turn-off of low-side semiconductor switches illustrating the current flow through the branches of half-bridges of the bridge leg arrangement.
- Fig. 5: shows timing diagrams during turn-off of low-side semiconductor switches illustrating a reduced rate of change of voltage increase at the midpoint of the bridge leg arrangement.
- Fig. 6: shows the bridge leg arrangement according to Fig. 2 together with commutation current loop paths through a DC bus for each of the half-bridges.
- Fig. 7: illustrates the voltage across the low-side semiconductor switch of a conventional bridge leg arrangement.
- Fig. 8: shows the voltage across the low-side semiconductor switches of the half-bridges of the bridge leg arrangement when considering skew between gate-driving signals according to the invention.

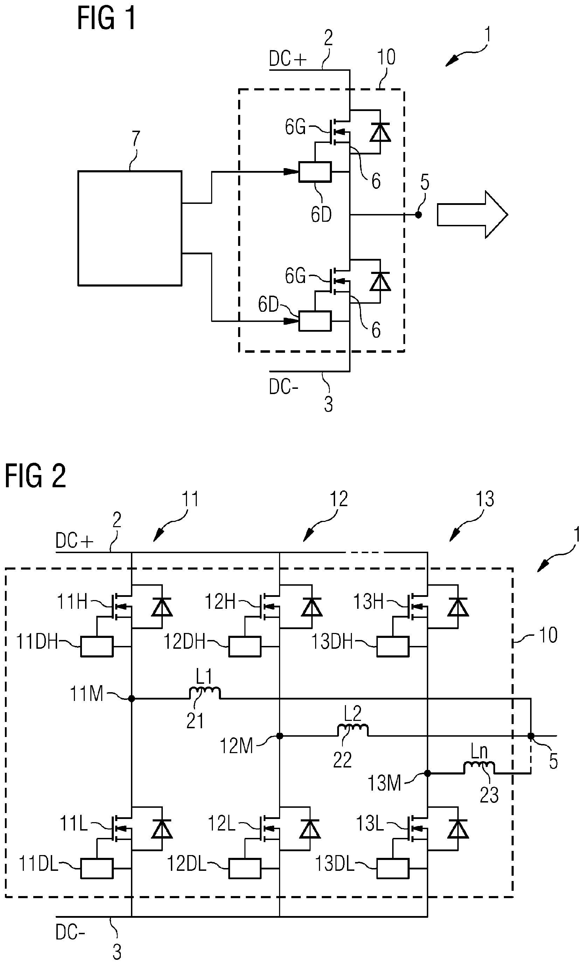

Fig. 1 shows a conventional power semiconductor bridge leg arrangement 1 according to the prior art. The bridge leg arrangement 1 comprises a first connection point 2 of a busbar (DC+) which is connected to a positive terminal of a not shown voltage source. A second connection point 3 of a busbar (DC-) is connected to a negative terminal of the not shown voltage source. A switching arrangement 10 comprising two semiconductor switching elements 6 (= semiconductor device) connected in series between the first connection point 2 and the second connection point 3, thereby forming a half-bridge module. A midpoint 5 between the series-connected switching elements 6 represents an output of the semiconductor bridge leg arrangement 1.

In order to turn the switching elements 6, in particular a (SiC or Si)-MOSFET or an (SiC or Si)-IGBT, on or off via a gating signal, each gate 6G is connected to a driver 6D. The respective driver 6D receives a triggering signal from a control circuit 7 for controlling the number of semiconductor switching elements 6 in a predetermined way in order to connect the midpoint (output) 5 to the positive first connection point 2 or the negative second connection point 3. The bridge leg arrangement 1 as shown in Fig. 1 may be used in an inverter in order to transform DC-current into AC-current. As known to the people skilled in the art, a bridge leg arrangement 1 as shown in Fig. 1 is provided for each phase of a multi-phase arrangement.

Fig. 2 illustrates a power semiconductor bridge leg arrangement according to the invention. The switching arrangement 10 comprises at least two individual power semiconductor half-bridge modules 11, 12, 13 connected in parallel between the first connection point 2 and the second connection point 3. By way of example only, three parallel power semiconductor half-bridge modules 11, 12, 13 are illustrated. However, it is to be understood that the number of half-bridge modules is arbitrary as long as the number of half-bridge modules is 2 or greater.

Each half-bridge module 11, 12, 13 comprises a high-side semiconductor switch 11H, 12H, 13H (= semiconductor device) and a low-side semiconductor switch 11L, 12L, 13L (= semiconductor device). A series connection of one high-side semiconductor switch 11H, 12H, 13H and associated low-side semiconductor switch 11L, 12L, 13L is connected to a half-bridge midpoint 11M, 12M, 13M. In the present embodiment, each half-bridge midpoint 11M, 12M, 13M is connected to the midpoint 5 of the bridge leg arrangement 1 with a dedicated designed inductance L1, L2, L3. The dedicated designed inductances L1, L2, L3 are composed of individual wound inductors 21, 22, 23. However, it is to be understood that the dedicated designed inductances L1, L2, L3 may be parasitic inductances of busbar or cabling used to connect a respective half-bridge midpoint 11M, 12M, 13M to the midpoint 5 as well.

The not shown control circuit is adapted to individually control the switch operations of each semiconductor switch 11H, 11L, 12H, 12L, 13H, 13L of the at least two individual power semiconductor half-bridge modules 11, 12, 13, in particular with respect to the timing.

In other words, the power semiconductor bridge leg arrangement 1 is formed by the parallel connection of a plurality of individual half-bridges 11, 12, 13, with a dedicated designed inductance L1, L2, L3 connected at the midpoint 11M, 12M, 13M of each individual half-bridge 11, 12, 13 and individual gate-drivers 11DH, 11DL, 12DH, 12DL, 13DH, 13DL. From an external converter perspective, the bridge leg arrangement 1 constitutes and can be operated as a single bridge leg as shown in Fig. 1.

The control circuit is adapted to generate an individual dedicated control signal for each semiconductor switch 11H, 11L, 12H, 12L, 13H, 13L of the number of half-bridge modules 11, 12, 13 and provide this signal to its associated driver 11DH, 11DL, 12DH, 12DL, 13DH, 13DL. In particular, the control circuit is adapted to skew the switching on/off triggering signals of each semiconductor switch 11H, 11L, 12H, 12L, 13H, 13L of each half-bridge module 11, 12, 13.

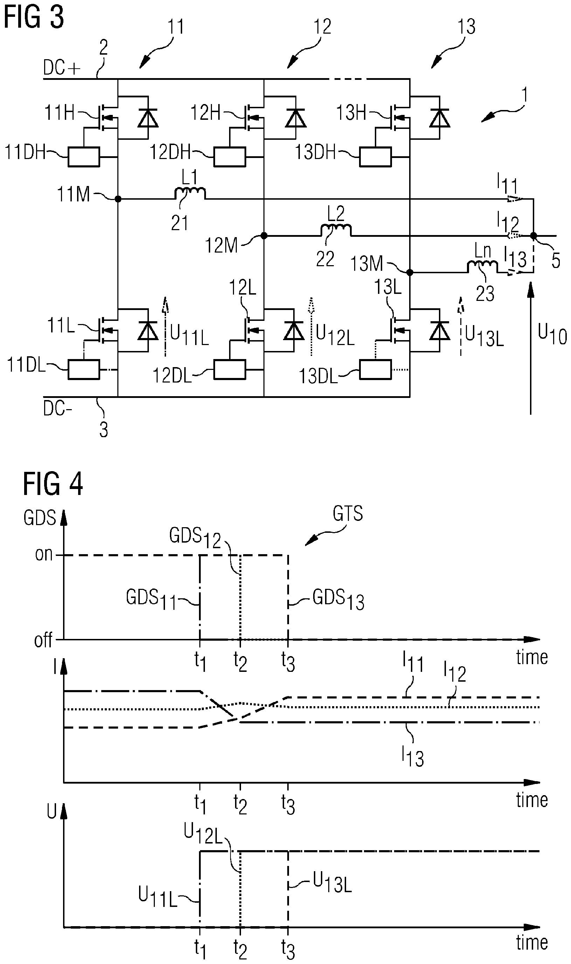

By skewing the switching on/off gate triggering signals of each individual power semiconductor half-bridge 11, 12, 13 within the bridge leg arrangement 1 a mechanism for balancing the currents flowing through each half-bridge 11, 12, 13 that form the overall bridge leg arrangement 1 is achieved. The respective balancing inductors 21, 22, 23 limit the magnitude of change in current during the switching transition. By controlling the order in which the individual semiconductor switches 11H, 11L, 12H, 12L, 13H, 13L are turned-on/turned-off active control over the balancing of the currents I₁₁, I₁₂, I₁₃ (see Fig. 3) flowing through each individual half-bridge 11, 12, 13 can be achieved. This is because the difference in half-bridge midpoint voltages results in a current flowing between the parallel half-bridges 11, 12, 13, limited in magnitude by the length of the timing skew and the magnitude of the inductance of the inductors 21, 22, 23.

Opportunities to achieve active current balancing are therefore present at every switching event (both turn-on and turn-off) the composite power semiconductor half-bridge 11, 12, 13 undergoes. The timing skew between half-bridges is in the region between 5 ns and 100 ns, preferably in a range between 5 ns and 50 ns, and more preferably in a range between 5 ns und 25 ns. As a result of this, the size of the required balancing inductors 21, 22, 23 is far below the size required for implementing converter level current control schemes.

Fig. 3 illustrates the bridge-leg arrangement 1 according to Fig. 2, in which in addition to the semiconductor elements and inductors respective voltages U_{11L}, U_{12L}, U_{13L} over the low-side semiconductor switches 11L, 12L, 13L, half-bridge currents I₁₁, I₁₂, I₁₃ and a resulting overall voltage U₁₀ of the midpoint 5 of the bridge leg arrangement 1 are illustrated.

Fig. 4 shows timing diagrams during turn-off of the low-side semiconductor switches 11L, 12L, 13L in the respective half-bridges 11, 12, 13 and the midpoint currents I₁₁, I₁₂, I₁₃.

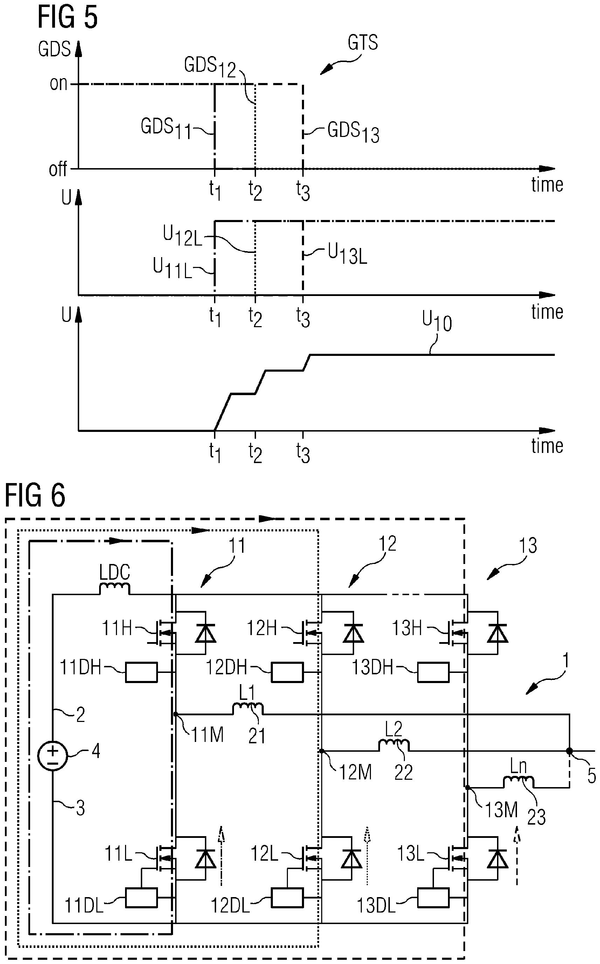

Fig. 5 shows the timing diagram in which the resulting voltage U₁₀ at the midpoint 5 of the bridge leg arrangement 1 is illustrated.

As can be seen from Fig. 4, where GDS represents the gate-driver state of the respective low-side semiconductor switch 11L, 12L, 13L, the low-side semiconductor switches 11L, 12L, 13L change their state from "on" to "off" with a time difference in-between. More specifically, low-side semiconductor switch 11L changes its state from on to off at time t=t₁, followed by low-side semiconductor switch 12L at t=t₂ and low-side semiconductor switch 13L at t=t₃. The time difference t₂-t₁ and t₃-t₂, respectively, between the respective two control signals represents the above-mentioned time skew.

As can be seen from the U-t-diagram in Fig. 4, the drain-source voltage across a respective low-side semiconductor switch 11L, 12L, 13L increases from 0 to a voltage value at the time GDS changes from on to off. At the same time, the midpoint currents I₁₁, I₁₂, I₁₃ of the respective half-bridges 11, 12, 13 are balanced, where the timing diagram of the resulting voltage at the midpoint 5 shows that the dV/dt at the midpoint 5 of the bridge leg arrangement 1 is also reduced in comparison to the case of a single half-bridge switching or all bridge switching simultaneously. This is due to an increase in the duration of time it takes the midpoint voltage U₁₀ to transition between positive/negative DC-rail voltage (DC+ or DC-) during turn-on/turn-off because of the gating time skew (see Fig. 5).

Fig. 6 illustrates the bridge leg arrangement 1 considering the inclusion of a parasitic inductance LDC of the DC bus. Commutation current loop paths through the DC bus for each of the half-bridges 11, 12, 13 within the semiconductor bridge leg are illustrated in addition. It is to be noted that a combination of any busbar/connection parasitic inductance and the parasitic inductions of any DC bus capacitors may form the parasitic inductance LDC. The following additional benefits arise from the skewing of the gate driving signals.

The overall effective dI/dt though the DC bus parasitic inductance LDC can be reduced due to the skewed switching of each switching switch 11H, 11L, 12H, 12L, 13H, 13L. This reduces voltage overshoot experienced by each of the semiconductor switches 11H, 11L, 12H, 12L, 13H, 13L during turn-off, as well as the energy-loss incurred during the switching transition of each individual device 11H, 11L, 12H, 12L, 13H, 13L. The magnitude of this benefit can be increased by ensuring the skew corresponds to the same order of the LC oscillation frequency of the respective semiconductor switch 11H, 11L, 12H, 12L, 13H, 13L, resulting in further reductions in dI/dt across the parasitic inductance LDC due to destructive interference between the different commutation currents. The skew could be selected through either experimental testing or simulation such that this destructive interference effect is maximized.

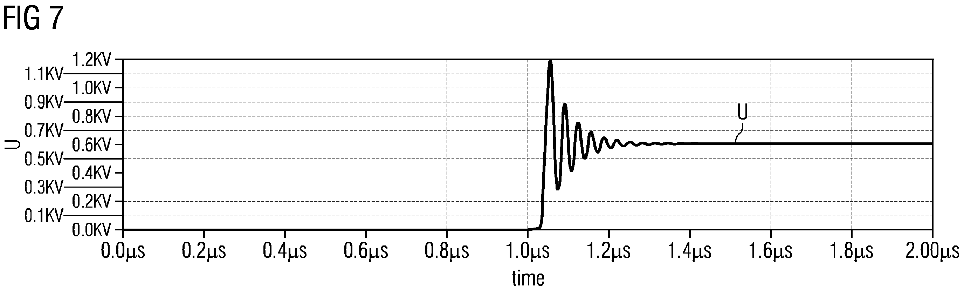

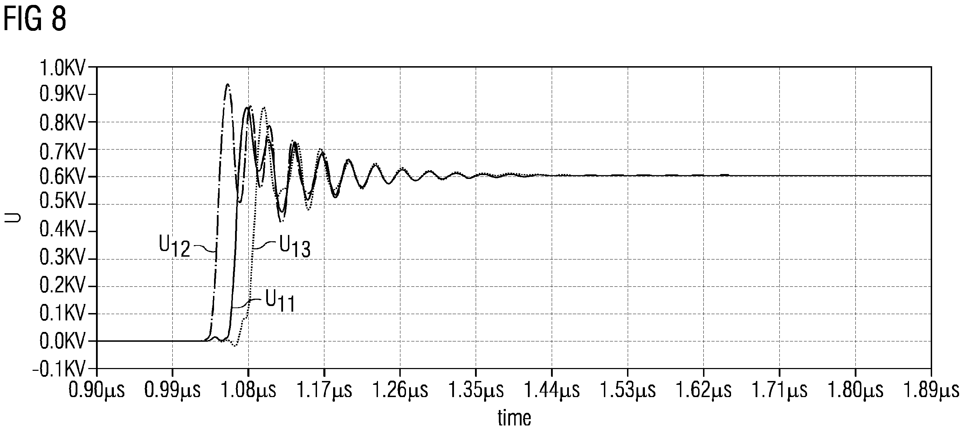

Figs. 7 and 8 show a comparison between device voltage overshoot during turn-off of the bridge leg arrangement 1 where Fig. 7 shows the behavior according to the prior art and Fig. 8 shows the behavior according to the bridge leg arrangement 1 of the invention.

As can be seen from Fig. 8, the voltage across the low-side devices U₁₁, U₁₂, U₁₃ when considering skew between gate-driving signals achieves reduced voltage overshoot across each semiconductor switch 11L, 12L, 13L. Voltage overshoot across the low side semiconductor switch of the conventional half-bridge according to Fig. 1 is approximately 600 V. This can be taken from Fig. 7. As can be seen from Fig. 8, the voltage overshoot across the first switching device (semiconductor switch 12L) is approximately 350 V with an approximate 270 V overshoot across the second and third device (low side switching elements 11L, 13L). The simulation performed in Figs. 7 and 8 uses the same circuit parameters.

The proposed invention uses sub-microsecond delays to achieve balancing, meaning that the required timing skews are achievable on a FPGA (Field Programmable Gate Array).

The bridge leg arrangement according to the invention does not rely upon precise matching of circuit impedance and device characteristic matching and is robust against characteristic variation due to aging and environmental factors.

The bridge leg arrangement according to the invention achieves current balancing in parallel half-bridges through a combination of additional designed inductances for limiting the magnitude of change in currents during the switching transition and active gate-driving in terms of introducing intentional timing skew between. The proposed bridge leg arrangement utilizes a combination of additional inductances and active gate driving in terms of adding skew between turn-on/turn-off gating signals of individual devices. The additional inductances consist of dedicated designed inductances which are composed of individual inductors, either wound inductors or parasitic inductances of a busbar or cabling.

The use of dedicated designed inductances (wound inductors or parasitic inductances) allows using an odd or even number of half-bridges to be paralleled. Use of wound inductors contrary to interphase transformers yields a reduced size when compared to the use of dedicated interphase transformers. The invention scales down to operation with parasitic inductances and thus needs no dedicated magnetic components.

### References

[1] Fuchslueger, H. Ertl, and M. A. Vogelsberger, "Reducing dv/dt of Motor Inverters by Staggered-Edge Switching of Multiple Parallel SiC Half-Bridge Cells," in PCIM Europe 2017; International Exhibition and Conference for Power Electronics, Intelligent Motion, Renewable Energy and Energy Management, May 2017, pp. 1-8
[2] D. Reiff, S. Johannliemke, and V. Staudt, "Active Current Balancing for Paralleled SiC Semiconductors in Time-Staggered Switching Mode," IEEE Transactions on Industry Applications, pp. 1-10, 2023.
[3] D. Reiff, S. Johannliemke, and V. Staudt, "Active Current Balancing for Paralleled SiC Semiconductors in Time-Staggered Switching Mode," in 2021 International Aegean Conference on Electrical Machines and Power Electronics (ACEMP) & 2021 International Conference on Optimization of Electrical and Electronic Equipment (OPTIM), Sept. 2021, pp. 205-211.

## Claims

1. A power semiconductor bridge leg arrangement (1), comprising:
- a first connection point (2) and a second connection point (3), which are to be connected to a DC-voltage source (4), and a midpoint (5) as output;
- a switching arrangement (10) having a number of semiconductor switching elements (6) connected between the first connection point (2) and the second connection point (3); and
- a control circuit (7) for controlling the number of semiconductor switching elements (6) of the switching arrangement (10);
**characterized in that**
- the switching arrangement (10) comprises at least two individual power semiconductor half-bridge modules (11, 12, 13) connected in parallel between the first connection point (2) and the second connection point (3), each half-bridge module (11, 12, 13) comprising a high-side semiconductor switch (11H, 12H, 13H) and a low-side semiconductor switch (11L, 12L, 13L) being connected to a half-bridge midpoint (11M, 12M, 13M), where the half-bridge midpoint (11M, 12M, 13M) is connected to the midpoint (5) of the bridge leg arrangement(1) with a dedicated designed inductance (L1, L2, L3); and
- the control circuit (7) is adapted to individually control the switch operations of each semiconductor switch (11H, 11L, 12H, 12L, 13H, 13L) of the at least two individual power semiconductor half-bridge modules (11, 12, 13).

2. The power semiconductor bridge leg arrangement according to claim 1, **characterized in that** the control circuit (7) is adapted to generate an individual dedicated control signal for each semiconductor switch (11H, 11L, 12H, 12L, 13H, 13L) of the at least two individual power semiconductor half-bridge modules (11, 12, 13) and provide it to an associated driver (11DH, 11DL, 12DH, 12DL, 13DH, 13DL).

3. The power semiconductor bridge leg arrangement according to claim 1 or 2, **characterized in that** the control circuit (7) is adapted to skew the switching on/off triggering signals of each individual power semiconductor half-bridge module (11, 12, 13).

4. The power semiconductor bridge leg arrangement according to claim 3, **characterized in that** the control circuit (7) is adapted to control the order in which the individual semiconductor switches (11H, 11L, 12H, 12L, 13H, 13L) of the at least two individual power semiconductor half-bridge modules (11, 12, 13) are turned-on/turned-off to control balancing of the currents flowing through each individual half-bridge module (11, 12, 13).

5. The power semiconductor bridge leg arrangement according to claim 4, **characterized in that** the control circuit (7) is adapted to control the order of switching based on phase measurements or based on a given schedule.

6. The power semiconductor bridge leg arrangement according to claim 4 or 5, **characterized in that** the timing skew between two individual bridge modules (11, 12, 13) is in a range between 5ns and 100ns, preferably in a range between 5ns and 50ns, and more preferably in a range between 5ns and 25ns.

7. The power semiconductor bridge leg arrangement according to one of the preceding claims 3 to 6, **characterized in that** the timing skew between two individual bridge modules (11, 12, 13) corresponds to the same order of a LC oscillation frequency of the power semiconductor bridge leg arrangement (1) .

8. The power semiconductor bridge leg arrangement according to one of the preceding claims, **characterized in that** the dedicated designed inductances (L1, L2, L3) are composed of individual inductors (21, 22, 23), either wound inductors or parasitic inductances of a busbar or cabling.

9. The power semiconductor bridge leg arrangement according to one of the preceding claims, **characterized in that** the number of dedicated designed inductances (L1, L2, L3) corresponds to the order of the number of individual power semiconductor half-bridge modules (11, 12, 13).

10. The power semiconductor bridge leg arrangement according to one of the preceding claims, **characterized in that** the number of individual power semiconductor half-bridge modules (11, 12, 13) is even or odd.

11. The power semiconductor bridge leg arrangement according to one of the preceding claims, **characterized in that** the semiconductor switches (11H, 11L, 12H, 12L, 13H, 13L) are MOSFETs or IGBTs.
